# EUROPEAN PATENT APPLICATION

(11) **EP 3 302 010 A1**
(43) Date of publication of application: **04.04.2018**
(21) Application number: 16191872.7
(22) Date of filing: 30.09.2016
(51) Int. Cl.: H05K 3/02, C04B 37/02, H05K 3/38, H05K 1/03

(54) **CIRCUIT BOARD AND METHOD FOR PRODUCING A CIRCUIT BOARD**

(71) Applicant: Infineon Technologies AG, 85579 Neubiberg (DE)
(72) Inventor: Roth, Alexander, 93197 Zeitlarn (DE)
(74) Representative: Westphal, Mussgnug & Partner Patentanwälte mbB

(57) **Abstract**

One aspect relates to a method for producing a circuit board. A copper-containing metal foil 11, 12 is disposed on a copper and oxygen containing coating 21', 22' of a carrier 10 so that the coating adjoins both the metal foil 11, 12 and a ceramic surface 10t, 10b of the carrier. The carrier, the coating and the metal foil are heated to at least a first temperature so that the coating and the metal foil unify, under the formation of a copper and oxygen containing eutectic, to a metallization layer. Subsequently, the carrier and the metallization layer are cooled to temperatures below the first temperature.

## Description

### TECHNICAL FIELD

The instant disclosure relates to a circuit board and to a method for producing a circuit board.

### BACKGROUND

Many electronic devices as, for instance, power semiconductor modules, employ metallised carriers as circuit boards for carrying one or more power semiconductor chips because they have a high thermal conductivity for dissipating heat from the power semiconductor chip(s), a coefficient of thermal expansion that does not differ too greatly from the coefficient of thermal expansion of usual power semiconductor chips, and a high dielectric strength. As the metallisation of the metallised carrier is used to provide electrically conducting paths, it often includes copper because the high electrical and thermal conductivity of copper is favourable for achieving both a high ampacity and good heat spreading properties. In order to produce such circuit boards, pre-fabricated, copper-containing metal foils are directly attached to the carrier at high temperatures. This process is also known as DCB-process (DCB = direct copper bonding). However, due to an unavoidable unevenness of pre-fabricated, copper-containing metal foils and carriers, conventional methods for producing such a circuit board suffer from gas-filled voids at the interface between the carrier and the metallisation. When high electric voltages are applied to the circuit board, a partial discharge may occur in the gas-filled voids, causing damage to the circuit board.

Hence, there is a general need for a method for producing a circuit board that has a copper-containing metallisation attached to a carrier and that has a high partial discharge resistance.

### SUMMARY

One aspect relates to a method for producing a circuit board. A copper-containing metal foil is disposed on a copper and oxygen containing coating of a carrier so that the coating adjoins both the metal foil and a ceramic surface of the carrier. The carrier, the coating and the metal foil are heated to at least a first temperature so that the coating and the metal foil unify, under the formation of a copper and oxygen containing eutectic, to a metallization layer. Subsequently, the carrier and the metallization layer are cooled to temperatures below the first temperature.

A further aspect relates to a circuit board comprising a copper-containing metallisation formed on a ceramic surface of a carrier, wherein there is no gas-filled void that is directly bounded by both the copper-containing metallisation and the ceramic surface and has, in a direction perpendicular to a plane, which is tangent to at least three different, non-linear points of the ceramic surface but does not intersect the carrier, a maximum dimension of more than 30 µm.

Examples are explained below with reference to the drawings. The drawings serve to illustrate certain principles, so that only aspects necessary for understanding these principles are illustrated. The drawings are not to scale. In the drawings the same reference characters denote like features.

### BRIEF DESCRIPTION OF THE DRAWINGS

Figures 1 to 7 are cross-sectional views illustrating several steps of producing a circuit board having a carrier.
Figure 8 is a cross-sectional view illustrating an enlarged section A of the circuit board of Figure 7.
Figure 9 is a cross-sectional view illustrating an enlarged section B of the circuit board of Figure 7
Figure 10 is a cross-sectional view illustrating a circuit board having a structured metallisation.
Figure 11 is a cross-sectional view illustrating the circuit board after being equipped with a semiconductor chip.
Figure 12 is a cross-sectional view illustrating the heating of the carrier, the copper-containing foil and the copper-containing layer in a heating process to temperatures of at least 1065°C.
Figure 13 is a cross-sectional view illustrating the cooling of the heated carrier and the cooling of a metallisation formed from the copper-containing foil and the copper-containing layer in a cooling process to temperatures of less than 1065°C.
Figure 14 is a cross-sectional view illustrating the production of a copper-containing layer on a carrier by spraying a copper-containing solution onto the carrier.
Figure 15 is a cross-sectional view illustrating the production of a copper-containing layer on a carrier by immersing the carrier into a copper-containing solution.
Figure 16 is a cross-sectional view illustrating the drying of the copper-containing solution applied to the carrier.
Figure 17 illustrates various steps of a method for producing a circuit board according to a first example.
Figure 18 illustrates various steps of a method for producing a circuit board according to a second example.
Figure 19 illustrates various steps of a method for producing a circuit board according to a first example.
Figures 20 and 21 are cross-sectional views illustrating how a number of circuit boards may be produced simultaneously and subsequently singulated.

In the following detailed description, reference is made to the accompanying drawings. The drawings form a part of the description and by way of illustration show specific examples in which the invention may be practised. It is to be understood that the features of the various examples described herein may be combined with each other, unless specifically noted otherwise.

### DETAILED DESCRIPTION

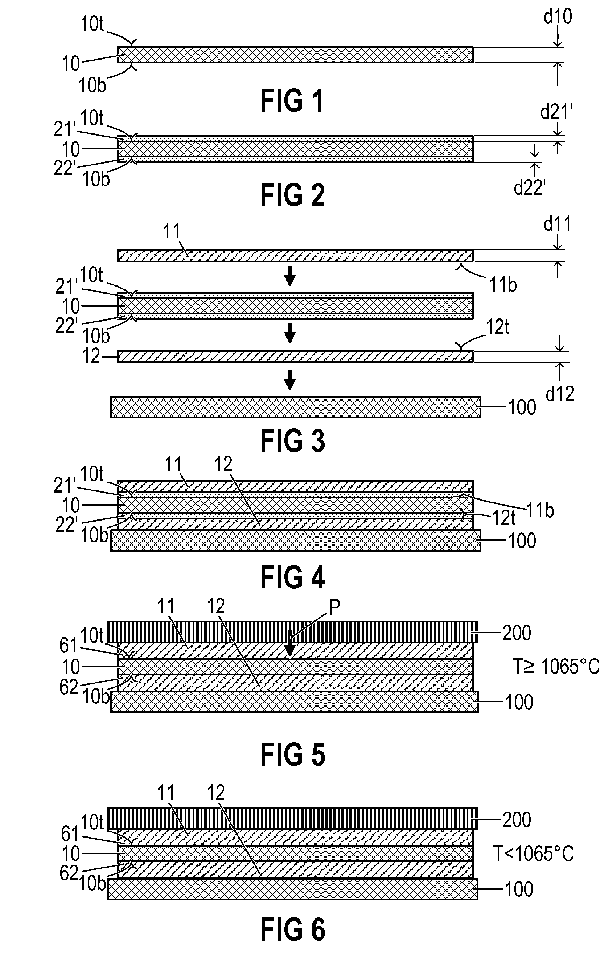

Figure 1 schematically illustrates an exemplary carrier 10 having a first ceramic surface 10t, and, a second surface 10b opposite the first ceramic surface 10t. Optionally, the second surface 10b may be a ceramic surface. The carrier 10 may be a flat platelet with the first ceramic surface 10t and the second surface 10b being plane parallel and having a layer thickness d10. For instance, the layer thickness d10 may be 0.2 to 1 mm. However, a thickness d10 of less than 0.2 or of more than 1 is also applicable. The carrier 10 may consist of or at least comprise ceramic. Optionally, the carrier 10 may be a ceramic carrier, i.e. a carrier that consists of ceramics.

Suitable ceramic materials forming a ceramic carrier 10 or at least the first ceramic surface 10t and, optionally, the second ceramic surface 10b, are, for example, oxides like aluminium oxide, magnesium oxide, uranium oxide, zirconium oxide, or zinc oxide. Alternatively, any carrier, the ceramic of which can be oxidised, e.g. magnesium aluminate or barium titanate or aluminium nitride carrier or silicon nitride, may be used as carrier 10 or to at least form the first ceramic surface 10t and, optionally, the second ceramic surface 10b.

As illustrated in Figure 2, a dry first copper-containing layer 21' having a layer thickness d21' is formed on the first ceramic surface 10t of the carrier 10 in order to subsequently attach a pre-fabricated copper-containing first metal foil 11 (see Figure 3) to the first ceramic surface 10t of the carrier 10. The first copper-containing layer 21' forms a coating of the carrier 10. The pre-fabricated copper-containing first metal foil 11 (see Figure 3) may consist of copper or contain at least 60 atom% (atom percent) copper and has a layer thickness d11. The layer thickness d21' of the first copper-containing layer 21' may be, for instance, selected from a range from 0.1 µm to 10 µm. However, a thickness d10 of less than 0.1 µm or of more than 10 µm is also applicable. The layer thickness d11 of the first metal foil 11 may be, for instance, selected from a range from 0.1 mm to 1 mm. However, a thickness d11 of less than 0.1 mm or of more than 1 mm is also applicable.

After forming the first copper-containing layer 21' on the first ceramic surface 10t of the carrier 10, the pre-fabricated first metal foil 11 is placed on the first copper-containing layer 21' so that the first copper-containing layer 21' is disposed between the carrier 10 and the first metal foil 11 and adjoins both the first ceramic surface 10t of the carrier 10 and the surface 11b of the first metal foil 11.

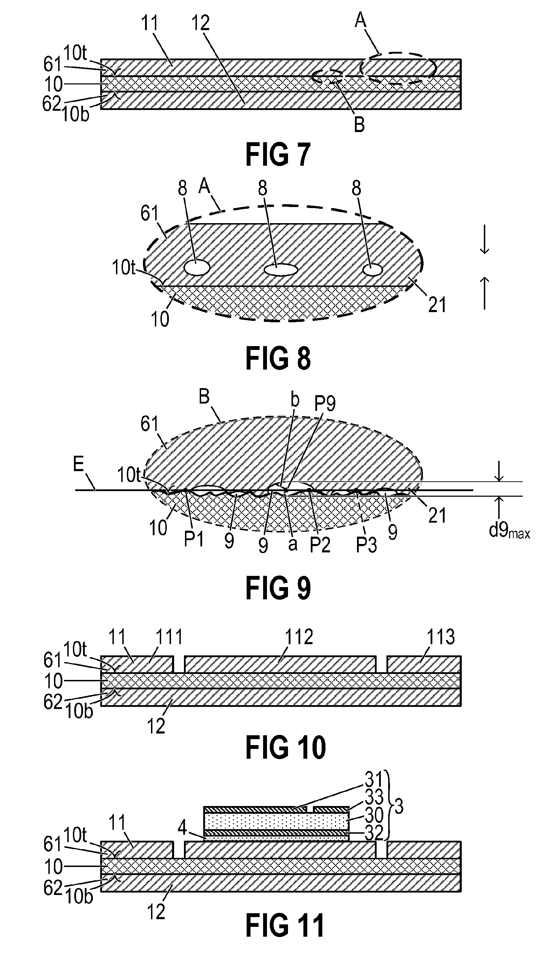

The first copper-containing layer 21' contains a chemical element or composition that includes and/or can be converted into at least one copper oxide, e.g. into at least one of CuO, Cu₂O, CuO₂, CuO₃, by heating the first copper-containing layer 21' in a heating process to high temperatures, for instance to temperatures of at least 70°C, e.g. to temperatures of 100°C to 150°C. By further heating the first copper-containing layer 21' with the first metal foil 11 attached to it so that the copper-containing layer 21' adjoins both the first ceramic surface 10t and the first metal foil 11, for instance to at least 200°C in a reductive or inert atmosphere, the copper oxide is reduced to metallic copper so that the metallic copper contained in the first copper-containing layer 21' forms a copper layer that is in close contact with the first ceramic surface 10t of the carrier 10 so that there exist no or no substantial gas-filled voids 9 (see Figure 9) between the copper layer and the first ceramic surface 10t. Industrially, this reduction may be performed, for instance, in a reduction process by heating the carrier 10, the first copper-containing layer 21'applied to the first ceramic surface 10t and the first foil 11 with the first copper-containing layer 21'disposed between and adjoining both the first ceramic surface 10t and the first foil 11 in a furnace to temperatures of more than 1000°C under an inert atmosphere, where the copper oxide dissociates into metallic copper (Cu) and gaseous oxygen (O₂). Depending on the duration of the reduction process and the temperature used in the reduction process, the dissociation can be complete so that substantially all of the copper oxide is dissociated. The degree of dissociation increases with the duration and the temperature used in the reduction process.

As illustrated in Figure 4, the carrier 10 with the first copper-containing layer 21' attached to the first ceramic surface 10t may optionally be placed on an auxiliary carrier 100, and the first metal foil 11 may be placed on the first copper-containing layer 21' applied to the first ceramic surface 10t so that the first copper-containing layer 21' is in physical contact with the first foil 11, disposed between and in physical contact with both the first ceramic surface 10t of the carrier 10 and the first metal foil 11.

In the same manner, an optional pre-fabricated copper-containing second metal foil 12 (see Figure 3) having a layer thickness d12 may be attached to the second surface 10b of the carrier 10 using a dry second copper-containing layer 22' which forms a coating of the carrier 10. For this, the second copper-containing layer 22', which may consist of copper or contain at least 60 atom% (atom percent) copper and has a layer thickness d22', is formed on the second surface 10b of the carrier 10 which. Because there is a second metal foil 12 attached to the second surface 10b, the second surface 10b is a ceramic surface. The layer thickness d22' of the second copper-containing layer 22' may be, for instance, selected from a range of 0.1 µm to 10 µm. The layer thickness d12 of the second metal foil 12 may be, for instance, selected from a range of 0.1 mm to 1 mm. However, a thickness d12 of less than 0.1 mm or of more than 1 mm is also applicable. It is to be noted that the layer thicknesses d10, d11, d12, d21 and d22 may be selected independently from one another. If there is no optional second metal foil 12 to be attached to the second ceramic surface 10b of the carrier 10, the second copper-containing layer 22' and the second metal foil 12 may be omitted.

If there is, as schematically illustrated in Figures 2 to 4, a pre-fabricated second copper-containing metal foil 11 to be attached to the second ceramic surface 10b of the carrier 10, the second copper-containing layer 22' is formed on the second ceramic surface 10b of the carrier 10, and, subsequently, the pre-fabricated second copper-containing metal foil 12 is placed on the second copper-containing layer 22' so that the second copper-containing layer 22' is disposed between the carrier 10 and the second copper-containing metal foil 12 and adjoins both the second ceramic surface 10b of the carrier 10 and the surface 12t of the second copper-containing metal foil 12, and that the carrier 10 is disposed between the first copper-containing layer 21' and the second copper-containing layer 22', and between the first copper-containing metal foil 11 and the second copper-containing metal foil 12.

In this state, as schematically illustrated in Figure 5, the carrier 10, the first metal foil 11, the first copper-containing layer 21', and, if provided, the second metal foil 12 and the second copper-containing layer 22' are heated in the heating process to temperatures of at least a minimum temperature, e.g. 1065°C, so that the first copper-containing layer 21' and the first metal foil 11 unify and form the first metallisation 61, and if provided, so that the second copper-containing layer 22' and the second metal foil 12 unify and form the second metallisation 62. In that heating process, at least one eutectic phase, which may consist of or comprise a copper-oxygen-eutectic, occurs.

After the heating process, the carrier 10, the first metallisation 61 and, if provided, the second metallisation layer 62 are, as schematically illustrated in Figure 6, cooled down to temperatures of less than the minimum temperature, for instance to temperatures of less than 50°C, e.g. to room temperature (20°C), in a cooling process. Prior to and/or during the mentioned heating process and the subsequent cooling process, copper contained in the chemical composition of the first copper-containing layer 21' and, if provided, the second copper-containing layer 22' is converted into at least one copper oxide (e.g. into at least one of CuO; Cu₂O; CuO₂; Cu₂O₃) and then reduced to metallic copper so that from copper contained in the first copper-containing layer 21', the first copper layer is joined with both the first ceramic surface 10t of the carrier 10 and the first metal foil 11, and, if there is also a second copper-containing layer 22', from copper contained in the second copper-containing layer 22', a second copper layer is formed that is joined with both the second ceramic surface 10b of the carrier 10 and the second metal foil 12.

During the heating process, the first metal foil 11 and the first copper-containing layer 21' unify so that they form a first metallisation 61 adjoining the first ceramic surface 10t. The first metallisation 61 may include layers having different materials or different material compositions emanating from first metal foil 11 and the first copper-containing layer 21', but it is also possible that the first metallisation layer 61 is fully alloyed so that it has a homogeneous material or material composition. Accordingly, when there is a second metal foil 12 joined to the second ceramic surface 10b of the carrier 10, the second metal foil 12 and the second copper-containing layer 22' unify during the heating process so that they form a second metallisation 62 adjoining the second ceramic surface 10b. The second metallisation 62 may include layers having different materials or different material compositions emanating from second metal foil 12 and the second copper-containing layer 22', but it is also possible that the second metallisation layer 62 is fully alloyed so that it has a homogeneous material or material composition.

Optionally, a weight 200 may be placed on that side of the first metal foil 11 facing away from the carrier 10 during the heating process so that potential gas-filled voids 9 (Figure 9) forming between the first copper-containing layer 21' and the first ceramic surface 10t and/or between the second copper-containing layer 22' and the second ceramic surface 10b are kept small. However, a pressure P that is exerted on the first ceramic surface 10t during the mentioned heating and cooling processes may be low and can therefore be generated without requiring expensive equipment. Therefore, the heating process and the subsequent cooling process may optionally be carried out with non-isostatic pressing. Nevertheless, hot isostatic pressing (HIP) may alternatively be used. For instance, the heating process and the subsequent cooling process may be carried out such that after one of the carrier 10, the copper-containing metal foil 11 and the copper-containing layer 21' has reached a temperature of at least 1065°C in the heating process and before each of the first copper-containing layer 21', the carrier 10 and the metallisation 61 has reached a temperature of less than 1065°C in the cooling process, a pressure P exerted on the first ceramic surface 10t does not exceed 30 MPa. However, it is to be noted that from a technical point of view, a pressure P higher than 30 MPa may be used as well. For instance, the heating process and the subsequent cooling process may be carried out hot isostatic pressing (HIP).

Independently of whether the pressure P is selected to exceed 30 MPa or not, it may be generated in a random manner, for instance using a weight 200 (in this case the pressure P is caused by the total combined weight of the weight 200, the self-weight of the first metal foil 11 and the self-weight of the copper-containing layer 21' or, from a later stage of the heating process on, by the total combined weight of the weight 200 and the self-weight of the first metallisation 61), or even without the weight 200 (in this case the pressure P is caused by the total combined weight of the self-weight of the first metal foil 11 and the self-weight of the copper-containing layer 21' or, from a later stage of the heating process on, by the self-weight of the first metallisation 61), but also using a press or by hot isostatic pressing.

Figure 7 illustrates the carrier 10 provided with the first metallisation 61 and the second metallisation 62 after the removal of the auxiliary carrier 100 and the weight 200.

As can be seen from Figure 8 which illustrates an enlarged section A of the circuit board of Figure 7, gas-filled voids 8 (emanating from an ambient atmosphere when the first metal foil 11 was placed on the first copper-containing layer 21') are disposed distant from the first ceramic surface 10t and therefore fully enclosed by metal. Therefore, an electric field inside the gas-filled voids 8 is zero so that an electrical field applied to the gas-filled voids 8 cannot cause a partial discharge in the region of the gas-filled voids 8. The gas-filled voids 8 are disposed distant from the first ceramic surface 10t because the copper-containing layer 21' was applied to the first ceramic surface 10t prior to placing the first metal foil 11 on the applied copper-containing layer 21'. Analogously, gas-filled voids emanating from an ambient atmosphere when the second metal foil 12 was placed on the second copper-containing layer 22' are disposed distant from the second ceramic surface 10b and therefore fully enclosed by metal.

As further shown in Figure 9 which illustrates an enlarged section B of the circuit board of Figure 7, small gas-filled voids 9 may happen to occur between the first ceramic surface 10t and the first metallisation 61. Different from the gas-filled voids 8 explained with reference to Figure 8, the gas-filled voids 9 are not fully enclosed by metal. Instead, they are directly bounded by both the first metallisation 61 and the first ceramic surface 10t of the carrier 10. That is, for each point P9 inside of a gas-filled void 9 there is at least one first continuous path a running only through the gas inside the gas-filled void 9 from that point P9 to the first ceramic surface 10t, and at least one second continuous path b running only through the gas inside the gas-filled void 9 from that point P9 to the first metallisation 61.

The problem of partial discharge caused by an electric field affecting a gas-filled void 9 can be reduced by keeping the maximum dimension the gas-filled void 9 has in the direction of the electric field low. Further, in many applications, an electrical field that might cause partial discharge at a gas-filled void 9 runs substantially perpendicular to the first ceramic surface 10t. With the present invention, gas-filled voids 9, if any, having low maximum dimensions in the direction perpendicular to the first ceramic surface 10t can be achieved.

As illustrated in Figure 9, a plane E can be defined which is tangent to at least three different, non-linear points P1, P2, P3 of the surface 10t of the carrier 10 and which does not intersect the carrier 10. It is to be noted that the reference line for point P3 is illustrated in dashed fashion in order to express that P3 is not located in the sectional plane of Figure 9. In a circuit board 100 of the present invention, first applying the copper-containing layer 21' to the first ceramic surface 10t and then placing the first metal foil 11 on the applied, copper-containing layer 21' allows for the production of a circuit board 100 in which there is no gas-filled void 9 that is directly bounded by both the first metallisation 61 and the first ceramic surface 10t of the carrier 10 and that has, in a direction perpendicular to the plane E, a maximum dimension d9ₘₐₓ of more than 30 µm or even of more than 10 µm.

A further option for keeping potential gas-filled voids 9 (Figure 9) from forming between the first ceramic surface 10t and the first metallisation 61 and/or, analogously, between the second ceramic surface 10b and the second metallisation 62 small is to ensure that the respective surfaces 10t, 10b of the carrier 10 are smooth so that no gas-filled voids 9 or at least no large gas-filled voids 9 are produced between the first ceramic surface 10t and the copper-containing layer 21' and/or, analogously, between the second ceramic surface 10b and the copper-containing layer 22', when a copper-containing material for producing the copper-containing layer(s) 21', 22' is applied to the respective surface 10t, 10b. For instance, such smooth surfaces 10t and/or 10b may be achieved by at least one of polishing and lapping.

Another additional or alternative option that can help prevent such potential gas-filled voids 9 or at least keep such potential gas-filled voids 9 small is to ensure that the respective surfaces 10t, 10b of the carrier 10 are, prior to applying the respective copper-containing layer 21', 22' to the respective surface 10t, 10b, free of large organic particles, for instance free of organic particles having a maximum particle length of more than 1 µm. Organic particles can be problematic as they can partly or even completely convert into gas when being heated to temperatures of at least 1065°C and therefore cause undesired gas-filled voids 9. Organic particles may be removed from the first ceramic surface 10t and the second ceramic surface 10b by heating the carrier 10, prior to applying a copper-containing material forming the respective copper-containing layer 21', 22' to the respective surface 10t, 10b, to temperatures of at least 400°C. At such high temperatures, most organic particles are decomposed or vapourized. Prior to the process of heating the carrier 10 to temperatures of at least 400°C, the carrier 10, which may be a fired green compact, may be subject to a pre-cleaning process, in which undesired remainders sticking to the carrier 10 are removed. Such remainders may be, for instance, abrasive dust resulting from polishing and/or lapping the carrier 10 at at least one of the surfaces 10t and/or 10b, an abherent like boron nitride (BN) that allows for separating the carrier 10 after the firing of the green compact from adjacent parts (e.g. from a pressing tool or from a further green compact fired commonly with the carrier 10) used in the firing process, or any other remainder. Optionally, the carrier 10 may have, after the pre-cleaning process but prior to heating it to temperatures of at least 400°C, a temperature of less than 100°C or even less than 50°C. Further, the pre-cleaning process may include mechanically cleaning the carrier 10, for instance by flushing the carrier 10 using a cleaning fluid (e.g. a liquid like water or a solvent, or a gas stream like an air stream).

The heating temperature process, in which the carrier 10, the first metal foil 11, the first copper-containing layer 21', and, if provided, the second metal foil 12 and the second copper-containing layer 22' are heated to temperatures of at least 1065°C, and the subsequent cooling process, in which the first metallisation 61 and (in case of a previous second metal foil 12 and a previous second copper-containing layer 22') are cooled to temperatures of less than 1065°C may be carried out such that the temperatures of at least 1065°C do not exceed the melting point(s) of the first metal foil 11 and the first metallisation 61, and, if provided, the melting point(s) of the second metal foil 12 and the second metallisation 62. Not exceeding a temperature of 1083°C during the heating process and the subsequent cooling process ensures that both the heating process and the cooling process are carried out at temperatures below the melting point of copper.

During the heating process and the subsequent cooling process, tight bonds between the carrier 10 and both the first metal foil 11 (i.e. between the first ceramic surface 10t and the first metallisation 61) and (if provided) the second metal foil 12 (i.e. between the second ceramic surface 10b and the second metallisation 62) are produced.

Then, if desired, the first metallisation 61 may be structured to include an arbitrary number and an arbitrary pattern of electrically conducting lines 111, 112, 113 which is schematically illustrated in Figure 10. For structuring, any conventional technique may be used. One suitable technique is, for example, masked etching of the first metallisation 61.

As further illustrated in Figure 11, the circuit board 100 may, after the mentioned cooling process, be equipped with at least one power semiconductor chip 3. The power semiconductor chip 3 is attached to the first metal foil 11 using a connection layer 4, for instance a solder, a sintered metal powder (e.g. a sintered silver powder), or an electrically conductive or electrically insulating adhesive. The connection layer 4 adjoins both the first metal foil 11 and the power semiconductor chip 3.

The power semiconductor chip 3 may include a semiconductor body 40 with a semiconductor component that has a load path formed between a first chip metallisation 31 and a second chip metallisation 32. Each of the first chip metallisation 31 and the second chip metallisation 32 is disposed on a surface of the semiconductor body 30. The semiconductor component may be, for instance, a diode, or a controllable semiconductor component like a unipolar or bipolar transistor or a thyristor. In case of a transistor, the controllable semiconductor component may be, for instance, an IGFET (Insulated Gate Bipolar Transistor) like a MOSFET (Metal Oxide Semiconductor Field-Effect Transistor) or an IGBT (Insulated Gate Bipolar Transistor), a JFET (Junction Field Effect Transistor), a HEMT (High Electron Mobility Transistor), a BJT (Bipolar Junction Transistor), or any other transistor.

The first chip metallisation 31 and the second chip metallisation 32 may be, for instance, a source metallisation and a drain metallisation, or a drain metallisation and a source metallisation, or an emitter metallisation and a collector metallisation, or a collector metallisation and an emitter metallisation, or an anode metallisation and a cathode metallisation, or a cathode metallisation and an anode metallisation. The semiconductor component may optionally be a vertical semiconductor component with the first chip metallisation 31 and the second chip metallisation 32 disposed on opposite surfaces of the semiconductor body 40.

In case of a controllable semiconductor component, the semiconductor chip 4 has a third chip metallisation 33. The third chip metallisation 33 is disposed on a surface of the semiconductor body 30, for instance on a surface facing away from the first metal foil 11, or on a surface of the semiconductor body 30 facing toward the first metal foil 11. The third chip metallisation may be, for instance, a gate metallisation or a base metallisation.

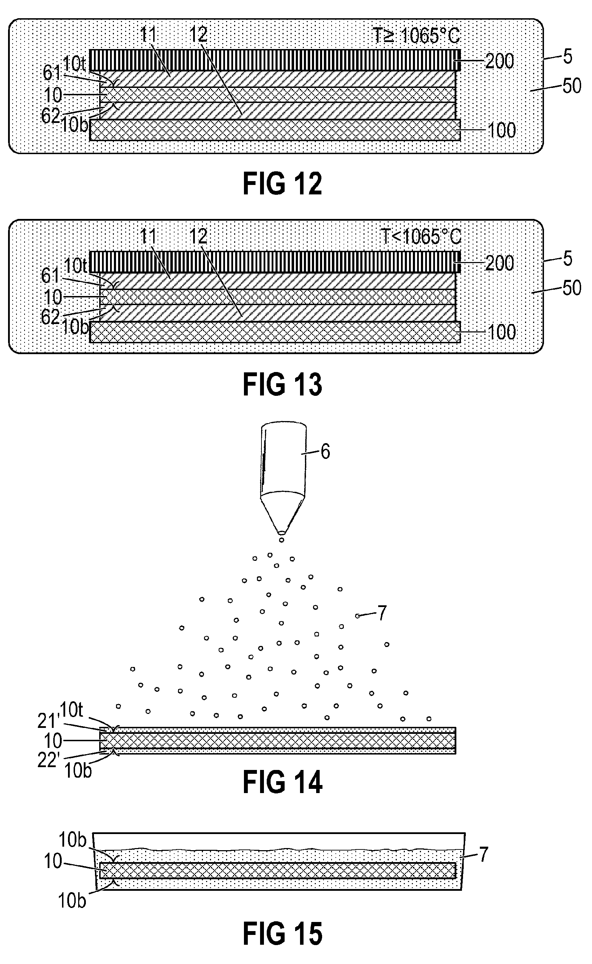

The mentioned temperature process (see also Figures 5 and 6) may optionally take place under ambient conditions. Alternatively, the temperature process may also be performed in a reactor 5 which is illustrated in Figures 12 and 13. Here, heating the carrier 10, the first metal foil 11 and the first copper-containing layer 21' and, if provided, the second metal foil 12, the second copper-containing layer 22', to temperatures of at least 1065°C (Figure 12, which already shows the first metal foil 11 and the first copper-containing layer 21' unified to the first metallisation 61 and the second metal foil 12 and the second copper-containing layer 22' unified to the first metallisation 61) and, optionally, the subsequent cooling process in which the mentioned parts are cooled down to temperatures below 1065°C, takes place in an atmosphere 50 surrounding the mentioned parts and fulfilling at least one of the following conditions: an absolute pressure of more than 0.8106 bar and less than 1.01325 bar; and an oxygen content of at most 5 atom percent. The atmosphere 50 may be provided in a reactor 5. Optionally, the atmosphere 50 may be inert. A suitable inert atmosphere may include, for instance, at least on of: nitrogen (N₂); argon (Ar); helium (He); neon (Ne); crypton (Kr); xenon (Xe).

In order to form the first copper-containing layer 21' on the first ceramic surface 10t of the carrier 10, and, optionally, to form the second copper-containing layer 22' on the second ceramic surface 10b of the carrier 10 (which is illustrated in Figure 2), the respective surfaces 10t, 10b are coated directly with a copper-containing material 7. That is, the copper-containing material 7 forms the first copper-containing layer 21' on the first ceramic surface 10t so that the copper-containing material 7 adjoins the first ceramic surface 10t, and, if provided, the second copper-containing layer 22' on the second ceramic surface 10b so that the copper-containing material 7 adjoins the second ceramic surface 10b. As will be explained below in more detail, the first copper-containing layer 21' is not attached in the form of a solid body (e.g. in the form of a metal foil) to the first ceramic surface 10t because this would cause undesired voids formed between the first ceramic surface 10t and the solid body. Accordingly, the second copper-containing layer 22', if provided, is not attached in the form of a solid body (e.g. in the form of a metal foil) to the second ceramic surface 10b because this would cause undesired voids formed between the first ceramic surface 10t and the solid body.

Instead, the first copper-containing layer 21' may be formed on the first ceramic surface 10t by at least one of: depositing a copper-containing material 7 on the first ceramic surface 10t in a deposition process; applying a copper-containing material 7 to the first ceramic surface 10t, which is, when it initially contacts the first ceramic surface 10t, fluid. Accordingly, the second copper-containing layer 22' may be formed on the second ceramic surface 10b by at least one of: depositing a copper-containing material 7 on the second ceramic surface 10b in a deposition process; applying a copper-containing material 7 to the second ceramic surface 10b, which is, when it initially contacts the second ceramic surface 10b, fluid. In this sense, "depositing" is to be understood in the sense of a deposition process, in which a copper-containing material 7 is deposited in the form of a plurality of atoms and/or molecules particles which are not part of a common solid body.

According to one example for forming the first copper-containing layer 21' on the first ceramic surface 10t, a copper-containing material 7 may be successively deposited on the first ceramic surface 10t (i.e. by growing the first copper-containing layer 21' on the first ceramic surface 10t), and/or by applying a copper-containing material 7 in liquid form to the first ceramic surface 10t (i.e. by wet application). Applying the copper-containing material 7 in liquid form to the first ceramic surface 10t may take place such that the copper-containing material 7, when it firstly comes into contact with the first ceramic surface 10t, is already in a liquid state. Accordingly, the second copper-containing layer 22', if provided, may be formed on the second surface 20t by successively depositing a copper-containing material 7 on the second surface 20t (i.e. by growing the second copper-containing layer 22' on the second ceramic surface 10b), and/or by applying a copper-containing material 7 in liquid form to the second ceramic surface 10b. Applying the copper-containing material 7 in liquid form to the second ceramic surface 10b may take place such that the copper-containing material 7, when it firstly comes into contact with the second ceramic surface 10b, is in a liquid state. If the copper-containing material 7 is applied in liquid form to the respective surface 10t and/or 10b, using a copper-containing material 7 having a melting point below room temperature (20°C) may facilitate the application process.

According to an example, in which the copper-containing layer 21' and 22' are grown on the respective surfaces 10t and 10b, respectively, the copper-containing material 7 may be released from a source 6 and deposited on the respective first ceramic surface 10t and second ceramic surface 10b, respectively, which is schematically illustrated in Figure 14. Depositing the copper-containing material 7 on the first ceramic surface 10t of the carrier 10, and, if desired, on the second ceramic surface 10b of the carrier 10 may take place by at least one of: physical vapour deposition (e.g. sputtering); and chemical vapour deposition. Suitable materials for physical vapour deposition (including sputtering) are, for instance, copper, aluminium (Al); all noble metals (e.g. silver (Ag); gold (Au); Platinum (Pt)). Suitable materials for chemical vapour deposition are, for instance, copper, copper-containing alloys with at least 60% Cu, as well as all noble metals (Au, Ag, Pt,...).

According to an example, in which the copper-containing layer 21' and 22' are applied to the respective surfaces 10t and 10b, respectively, in liquid form, the copper-containing material 7 may be a copper-containing solution which is applied to the respective first ceramic surface 10t and second ceramic surface 10b by at least one of: spraying the copper-containing solution 7 onto the respective surface 10t, 10b; dispensing the copper-containing solution 7 onto the respective surface 10t, 10b (see also Figure 14); and immersing the carrier 10 into the copper-containing solution 7 (see Figure 15). Suitable copper-containing solution may include, for instance, at least one of: copper(II) hydroxide; and copper(II) acetate. However, other copper-containing solutions that contain copper which can be converted into copper oxide may be used as well. During and/or after applying the copper-containing solution 7 to the respective first ceramic surface 10t and/or second ceramic surface 10b, the carrier 10 may be placed in a low pressure atmosphere, for instance in an atmosphere having an absolute pressure of less than 90% of the pressure of the ambient atmosphere, in order to avoid gas-filled voids between the respective surface 10t, 10b and the copper-containing solution 7 applied thereto.

It should be noted that a copper-containing layer 21', 22' may be produced on the respective surface 10t, 10b using only one or, alternatively, at least two of the methods mentioned above. In the latter case, any of the at least two methods may be combined with one another. Thereby, the at least two methods may be executed in any order. As a result, the respective final copper-containing layer 21', 22' includes a copper-containing first sub-layer which results from the method executed first and which directly contacts the respective surface 10t, 10b, a copper-containing second sub-layer which results from the method executed secondly and which directly contacts the first sub-layer so that the first sub-layer is disposed between the respective surface 10t, 10b and the second sub-layer, an optional copper-containing third sub-layer which results from the method executed thirdly and which directly contacts the second sub-layer so that the second sub-layer is disposed between the first sub-layer and the third sub-layer, and so on. That is, the respective copper-containing layer 21', 22' may be a stack composed of at least two copper-containing sub-layers. The number of sub-layers is identical to the number of the (subsequently executed) at least two methods. As far as one of the at least two methods, which uses a liquid copper-containing material 7, is followed by another one of the at least two methods, the liquid copper-containing material 7 applied in the one of the at least two methods may be dried prior to executing the other one of the at least two methods.

If there is a first copper-containing layer 21' to be produced on the first ceramic surface 10t and a second copper-containing layer 22' to be produced on the second ceramic surface 10b, producing the second copper-containing layer 22' on the second ceramic surface 10b may take place, irrespective of the method used, prior to, simultaneously with or after producing the first copper-containing layer 21' on the first ceramic surface 10t. It is also possible that copper-containing sub-layers are produced alternatingly on the first and second ceramic surfaces 10t, 10b.

As will be apparent from the above explanations, the pre-fabricated copper-containing first metal foil 11 may be directly attached to the completed first copper-containing layer 21' such that the first metal foil 11 adjoins a copper-containing material 7 that has been applied to the carrier 10 with one of the methods described above. If the completed first copper-containing layer 21' includes two or more sub-layers, the first metal foil 11 adjoins that one of those sub-layers that has been produced at last. Accordingly, the pre-fabricated copper-containing first metal foil 11, if provided, may be directly attached to the completed second copper-containing layer 22' such that the second metal foil 12 adjoins a copper-containing material 7 that has been applied to the carrier 10 with one of the methods described above. If the completed second copper-containing layer 22' includes two or more sub-layers, the second metal foil 12 adjoins that one of those sub-layers that has been produced at last.

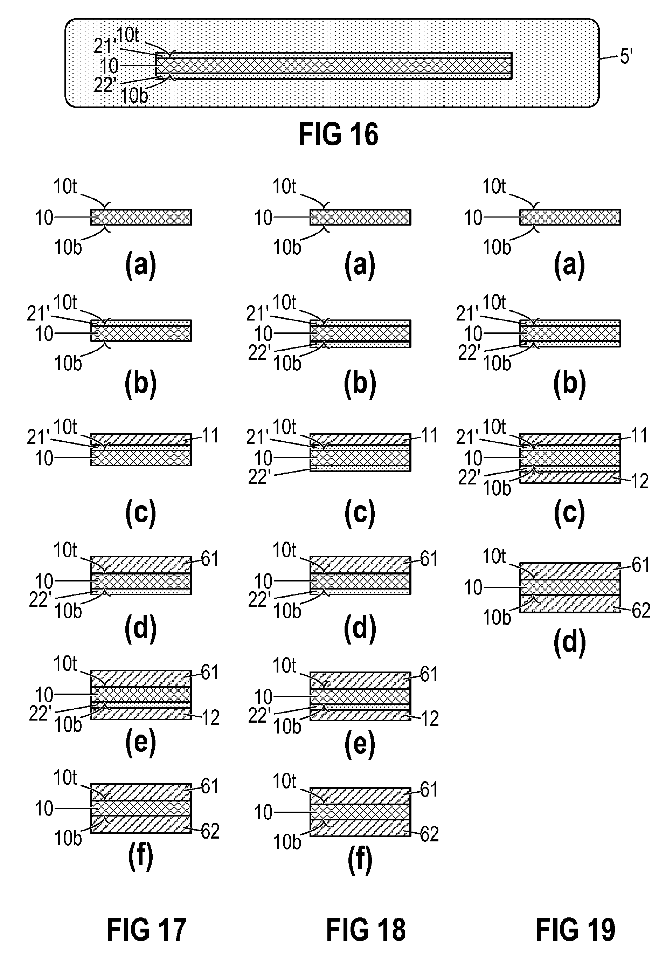

If a copper-containing liquid (e.g. a copper-containing solution) is used as the copper-containing material 7 applied to the first ceramic surface 10t, the applied copper-containing liquid is to be dried prior to placing the first metal foil 11 on the dried copper-containing "liquid" (which is equal to the dry first copper-containing layer 21'), and if a copper-containing liquid is used as the copper-containing material 7 applied to the second ceramic surface 10b, the applied copper-containing liquid is to be dried prior to placing the second metal foil 12 on the dried copper-containing "liquid" (which is equal to the dry second copper-containing layer 22'). Drying may optionally take place in a furnace 5' as illustrated in Figure 16. It is to be noted that the above-mentioned layer thicknesses d21', d22' relate to the dried copper-containing layers 21' and 22', respectively.

The above-described methods for producing copper-containing layers 21', 22' allow for a continuous coating of the respective surface 10t, 10b with the copper-containing material 7 so that there occur no or no substantial gas-filled voids caused by gas that is unintentionally enclosed between the carrier 10 and the respective copper layer resulting from the copper-containing layers 21'and 22', respectively.

In some of the examples described above, the copper-containing first foil 11 was joined to the first ceramic surface 10t of the carrier 10, and, simultaneously, the copper-containing second foil 12 was joined to the second surface 10b of the carrier 10. However, it is also possible to first join the copper-containing first foil 11 to the first ceramic surface 10t of the carrier 10 during a first temperature process, and subsequently join the copper-containing second foil 12 to the second surface 10b of the carrier 10 during a second temperature process. Thereby, each of the first and second temperature processes may include a heating process and a subsequent cooling process using the same parameters as described above.

In the described method, each of the first and/or second metal foils 11, 12 may optionally be structured to include conductive lines. In each case, structuring may take place prior to joining the respective metal foil 11, 12 with the carrier 10, for instance by stamping, or after joining the respective metal foil 11, 12 with the carrier 10, for instance by masked etching.

Each of Figures 17 to 19 illustrates various steps of a method for producing a circuit board. The methods explained with reference to Figures 17 to 19 differ in the order of the steps. According to the example of Figure 17, the carrier 10 is provided (step a). Then, the first copper-containing layer 21' is produced on the first ceramic surface 10t (step b) and, subsequently, the first metal foil 11 is placed on the applied first copper-containing layer 21' (step c). Subsequently, the first metal foil 11, the first copper-containing layer 21' and the carrier 10 are joined in heating process and a subsequent cooling process as described above, whereby the first metal foil 11 and the first copper-containing layer 21' unify and form the first metallisation 61. Subsequently, the second copper-containing layer 22' is produced on the second ceramic surface 10b (step d) and, subsequently, the second metal foil 12 is placed on the applied second copper-containing layer 22' (step e). Subsequently, the second metal foil 12, the second copper-containing layer 22' and the carrier 10 are joined in a heating process and a subsequent cooling process as described above, whereby the second metal foil 12 and the second copper-containing layer 22' unify and form the second metallisation 62 (step f).

According to the example of Figure 18, the carrier 10 is provided (step a). Then, the first copper-containing layer 21' is produced on the first ceramic surface 10t and the second copper-containing layer 22' is produced on the second ceramic surface 10b (step b). Subsequently, the first metal foil 11 is placed on the applied first copper-containing layer 21' (step c). Subsequently, the first metal foil 11, the first copper-containing layer 21' and the carrier 10 are joined in a heating process and a subsequent cooling process as described above, whereby the first metal foil 11 and the first copper-containing layer 21' unify and form the first metallisation 61 (step d). Subsequently, the second metal foil 12 is placed on the applied second copper-containing layer 22' (step e). Subsequently, the second metal foil 12, the second copper-containing layer 22' and the carrier 10 are joined in a heating process and a subsequent cooling process as described above, whereby the second metal foil 12 and the second copper-containing layer 22' unify and form the second metallisation 62 (step f).

According to the example of Figure 19, the carrier 10 is provided (step a). Then, the first copper-containing layer 21' is produced on the first ceramic surface 10t and the second copper-containing layer 22' is produced on the second ceramic surface 10b (step b). Subsequently, the first metal foil 11 is placed on the applied first copper-containing layer 21', and the second metal foil 12 is placed on the applied second copper-containing layer 22' (step c). Subsequently, in a heating process and a subsequent cooling process as described above, the first metal foil 11, the first copper-containing layer 21' and the carrier 10 are joined, whereby the first metal foil 11 and the first copper-containing layer 21' unify and form the first metallisation 61, and the second metal foil 12, the second copper-containing layer 22' and the carrier 10 are joined, whereby the second metal foil 12 and the second copper-containing layer 22' unify and form the second metallisation 62 (step d).

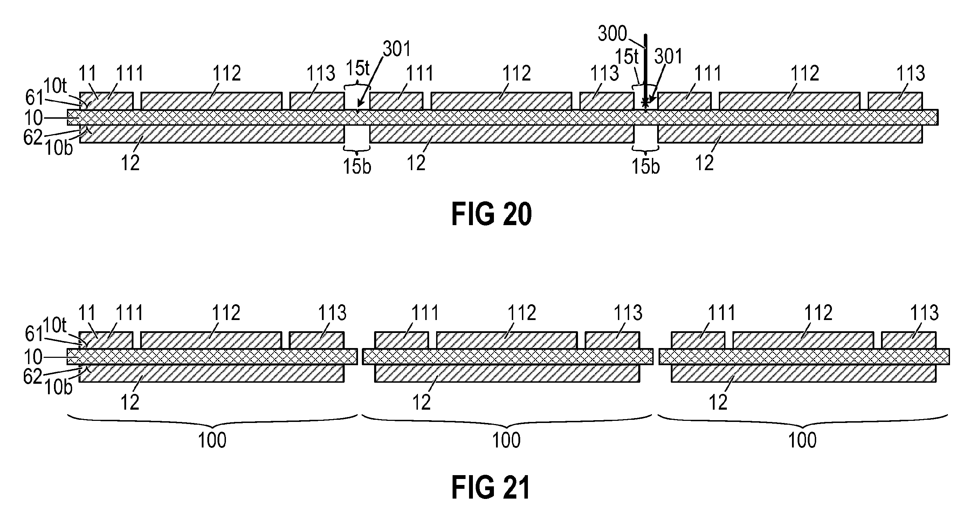

With the methods described above, a number of circuit boards may be produced simultaneously with the same processes and subsequently singulated. An example is illustrated in Figures 20 and 21. Figure 20 shows a panel with several circuit boards. The panel may be formed in the same manner as one of the circuits boards described above. Thereby, the carrier 10, the first metal foil 11 and the second metal foil 12 are common to all circuit boards. Additionally, the first metal foil 11 and the second metal foil 12 are, for instance during the mentioned masked etching process, structured such that the carrier 10 is exposed at opposing first sections 15b and second sections 15t of the carrier 10. The sections 15t are sections of the first ceramic surface 10t, and the sections 15b are sections of the second ceramic surface 10b. In the first sections 15t and/or in the second sections 15b of each opposing pair of first and second sections 15t/15b, a laser beam 300 produces scores 301 in the carrier 10 so that the circuit boards can easily be singulated by breaking the carrier 10 along the scores 301. Figure 21 shows the singulated circuit boards 100.

In the previous description, reference was made to the accompanying drawings. The drawings illustrate specific embodiments in which the invention may be practised. It is to be understood that the features and method steps of the various embodiments described herein may be combined with each other, unless specifically noted otherwise.

## Claims

1. A method comprising:
disposing a copper-containing metal foil on a copper and oxygen containing coating of a carrier so that the coating adjoins both the metal foil and a ceramic surface of the carrier;
heating the carrier, the coating and the metal foil to at least a first temperature so that the coating and the metal foil unify, under the formation of a copper and oxygen containing eutectic, to a metallization layer; and, subsequently,
cooling the carrier and the metallization layer to temperatures below the first temperature.

2. The method of claim 1, wherein the coating comprises a copper oxide.

3. The method of claim 1 or 2, wherein copper comprised in the coating is oxidized to a copper oxide so that the coating contains a copper oxide.

4. The method of claim 3, wherein copper comprised in the coating is oxidized to the copper oxide in the heating process.

5. The method of claim 3 or 4, wherein oxidizing copper comprised in the coating to the copper oxide takes place in a pre-heating process prior to disposing the copper-containing metal foil on the coating.

6. The method of any of the preceding claims, wherein the coating is formed on the surface of the carrier by applying a copper-containing material to the surface of the carrier.

7. The method of claim 6, wherein
the copper-containing material is a copper-containing fluid;
applying the copper-containing material to the surface of the carrier takes place by at least one of:
- immersing the carrier into the copper-containing fluid;
- spraying the copper-containing fluid onto the carrier;
- dispensing the copper-containing fluid onto the carrier; and
the coating is produced by drying the applied copper-containing material prior to disposing the copper-containing metal foil on the coating.

8. The method of claim 7, wherein the copper-containing fluid comprises at least one of: copper(II) hydroxide; and copper(II) acetate.

9. The method of one of claims 7 or 8, wherein the copper-containing fluid comprises a melting point of at least 20°C.

10. The method of any of claims 6 to 9, wherein applying the copper-containing material to the surface of the carrier comprises depositing a copper-containing material by at least one of: physical vapour deposition; or chemical vapour deposition.

11. The method of any of the preceding claims, wherein the copper-containing metal foil comprises at least 60 atom% copper.

12. The method of any of the preceding claims, wherein the coating is dry or dried and comprises, in a dry state and prior to disposing the copper-containing metal foil on the coating, a layer thickness from 0.1 µm to 10 µm.

13. The method of any of the preceding claims, wherein the heating process takes place in an atmosphere surrounding the substrate, the copper-containing metal foil and the coating, wherein the atmosphere comprises at least one of:
an absolute pressure of more than 0.8106 bar and less than 1.01325 bar; and
at most 5 atom percent oxygen.

14. The method of any of the preceding claims, wherein a pressure, with which the copper-containing metal foil and the coating are pressed against the surface of the carrier and with which, from a later stage of the heating process on, the metallisation is pressed against the surface of the carrier, and, after one of the carrier, the copper-containing metal foil and the coating has reached the first temperature in the heating process and before each of the carrier and the metallisation has reached a temperature of less than the first temperature in the cooling process, does not exceed 30 MPa.

15. A circuit board comprising a copper-containing metallisation formed on a ceramic surface of a carrier, wherein there is no gas-filled void that is directly bounded by both the copper-containing metallisation and the ceramic surface and has, in a direction perpendicular to a plane, which is tangent to at least three different, non-linear points of the ceramic surface but does not intersect the carrier, a maximum dimension of more than 30 µm.
